# EUROPEAN PATENT APPLICATION

(11) **EP 4 832 708 A1**
(43) Date of publication of application: **28.10.2026**
(21) Application number: 24913426.3
(22) Date of filing: 26.12.2024
(51) Int. Cl.: H10H 29/856, H10H 29/852, H10H 29/851, H10H 29/14, H10H 29/85

(54) **LIGHT EMITTING DEVICE AND DISPLAY INCLUDING SAME**

(30) Priority: 29.12.2023 US 202363616099 P; 05.01.2024 US 202463617865 P; 20.12.2024 US 202418990172
(71) Applicant: Seoul Semiconductor Co., Ltd., Gyeonggi-do 15429 (KR)
(72) Inventor: KO, Mi So, Ansan-si, Gyeonggi-do 15429 (KR); CHOI, Eun Mi, Ansan-si, Gyeonggi-do 15429 (KR)
(74) Representative: Isarpatent
(86) International application number: PCT/KR2024/021186
(87) International publication number: WO 2025/143819

(57) **Abstract**

A light emitting apparatus includes: a circuit board; a plurality of light emitting devices connected to the circuit board; and a reflective sheet that reflects light emitted from the plurality of light emitting devices and includes a plurality of reflective cells which respectively accommodate the plurality of light emitting devices. The plurality of reflective cells include a plurality of low-reflection patterns. The plurality of low-reflection patterns include a pattern disposed closer to an edge of the reflective sheet, size of which is relatively smaller than size of other patterns.

## Description

### TECHNICAL FIELD

The present disclosure relates to a light emitting apparatus and a display including the same.

### BACKGROUND ART

A display is a device that displays characters, symbols, images, or videos. The display may include a light emitting apparatus that emits light and a panel that controls the light emitted from the light emitting apparatus.

A light emitting apparatus includes a light-emitting surface that emits light, and when light is emitted evenly from the entire light-emitting surface, characters, symbols, images, or videos displayed on a display can be displayed more clearly. In other words, the higher the surface emission efficiency of the light emitting apparatus, the clearer the characters, symbols, images, or videos displayed on the display can be.

Conventionally, in order to increase the surface light emission efficiency of a light emitting apparatus, the light emitting apparatus includes a plurality of light emitting devices that emit light, and the spacing between the plurality of light emitting devices is adjusted or a diffusion plate is used to diffuse the light emitted from the light emitting devices. However, it is still not possible to resolve the fact that the central part of the light emitting surface of the light emitting apparatus is relatively brighter than the edges, so there is a limit to improving surface light emitting efficiency.

### DETAILED DESCRIPTION OF INVENTION

### TECHNICAL PROBLEMS

Embodiments of the present disclosure are anticipated in view of the above background, and provide a light emitting apparatus capable of improving surface light emission efficiency and a display including the same.

### TECHNICAL SOLUTION

In accordance with a first embodiment of the present disclosure, there is provided a light emitting apparatus including: a circuit board; a plurality of light emitting devices connected to the circuit board; and a reflective sheet that reflects light emitted from the plurality of light emitting devices and includes a plurality of reflective cells which respectively accommodate the plurality of light emitting devices, wherein the plurality of reflective cells include a plurality of low-reflection patterns, and wherein the plurality of low-reflection patterns are arranged such that some of the low-reflection patterns disposed closer to an edge of the reflective sheet have a relatively smaller size than the other low-reflection patterns. Alternatively, the plurality of low-reflection patterns decrease in saturation or brightness as the low-reflection patterns are arranged closer to the edge of the reflective sheet. This can prevent a decrease in luminance at the edge of the light emitting device.

In accordance with a second embodiment of the present disclosure, there is provided a light emitting apparatus including: a circuit board; a plurality of light emitting devices connected to the circuit board; and a reflective sheet that reflects light emitted from the plurality of light emitting devices and accommodates the plurality of light emitting devices, wherein the reflective sheet includes a plurality of low-reflection patterns, and some of the low-reflection patterns disposed farther from the light emitting device have a relatively smaller size than the other low-reflection patterns. Alternatively, the plurality of low-reflection patterns decrease in saturation or brightness as the low-reflection patterns are arranged closer to an edge of the reflective sheet.

In accordance with a third embodiment of the present disclosure, there is provided a display including: a light emitting apparatus for emitting light; and a panel for controlling light emitted from the light emitting apparatus, wherein the light emitting apparatus includes: a circuit board; a plurality of light emitting devices connected to the circuit board; and a reflective sheet that reflects light emitted from the plurality of light emitting devices and includes a plurality of reflective cells which respectively accommodate the plurality of light emitting devices, wherein the plurality of reflective cells include a plurality of low-reflection patterns, some of the low-reflection patterns disposed farther from the light emitting device have a relatively smaller size than the other low-reflection patterns. Alternatively, the plurality of low-reflection patterns decrease in saturation or brightness as the low-reflection patterns are arranged closer to an edge of the reflective sheet..

In accordance with a fourth embodiment of the present disclosure, there is provided a light emitting apparatus including: a circuit board; a plurality of light emitting devices connected to the circuit board; and a reflective sheet that reflects light emitted from the plurality of light emitting devices and accommodates the plurality of light emitting devices, wherein the reflective sheet includes: a main region; a side region disposed around the main region at an inclined angle with respect to the main region; and a low-reflection pattern disposed in the side region, wherein at least a portion of the plurality of light emitting devices is disposed in an area where a first direction arrangement region extending in a first direction and the main region overlap, wherein at least a portion of the low-reflection pattern is disposed in an area where the first direction arrangement region and the side region overlap, and wherein the first direction arrangement region is defined as a virtual region extending along the first direction in the main region and the side region while having a length in a second direction different from the first direction equal to a length in the second direction of at least one of the plurality of light emitting devices. Therefore, the luminance difference between the region where the light emitting device is disposed and the region where the light emitting device is not disposed can be reduced.

In accordance with a fifth embodiment of the present disclosure, there is provided a light emitting apparatus including: a circuit board; a plurality of light emitting devices connected to the circuit board; and a reflective sheet that reflects light emitted from the plurality of light emitting devices and accommodates the plurality of light emitting devices, wherein the reflective sheet includes: a main region; a side region disposed around the main region at an inclined angle with respect to the main region; and a plurality of low-reflection patterns disposed in the side region, wherein at least a portion of the plurality of low-reflection patterns are arranged in a convex curved shape to one side or the other side in a first direction. Therefore, the luminance of the light emitted in a peripheral direction of the light emitting device can be controlled.

In accordance with a sixth embodiment of the present disclosure, there is provided a display including: a light emitting apparatus for emitting light; and a panel for controlling light emitted from the light emitting apparatus, wherein the light emitting apparatus includes: a circuit board; a plurality of light emitting devices connected to the circuit board; and a reflective sheet that reflects light emitted from the plurality of light emitting devices and accommodates the plurality of light emitting devices, wherein the reflective sheet includes: a main region; a side region disposed around the main region at an inclined angle with respect to the main region; and a plurality of low-reflection patterns disposed in the side region, wherein at least a portion of the plurality of light emitting devices is disposed in an area where a first direction arrangement region extending in a first direction and the main region overlap, wherein at least a portion of the plurality of low-reflection patterns is disposed in an area where the first direction arrangement region and the side region overlap, and wherein the first direction arrangement region is defined as a virtual region extending along the first direction in the main region and the side region while having a length in a second direction different from the first direction equal to a length in the second direction of at least one of the plurality of light emitting devices.

### EFFECT OF INVENTION

According to embodiments of the present disclosure, the surface light emission effect can be improved by increasing the degree of reflection of light toward the edge of the light emitting apparatus.

Further, according to embodiments of the present disclosure, the light emitting apparatus capable of improving surface light emission efficiency and the display including the same are provided.

### BRIEF DESCRIPTION OF THE DRAWINGS

FIG. 1 is a diagram showing a portion of a cross section of a display according to a first embodiment of the present disclosure.
FIG. 2 is a plan view of the light emitting apparatus of the display of FIG. 1.
FIG. 3 is an enlarged view of part A of FIG. 2.
FIG. 4 is an enlarged view of part B of FIG. 3.
FIG. 5 is a cross-sectional view taken along line V-V of Fig. 4.
FIG. 6 is a part of a plan view of a first example of a light emitting apparatus of a display according to a second embodiment of the present disclosure.
FIG. 7 is a cross-sectional view of a light emitting device of the first example of the light emitting apparatus of the display according to the second embodiment of the present disclosure.
FIG. 8 is a cross-sectional view of a light emitting device of a second example of the light emitting apparatus of the display according to the second embodiment of the present disclosure.
FIG. 9 is a cross-sectional view of a light emitting device of a third example of the light emitting apparatus of the display according to the second embodiment of the present disclosure.
FIG. 10 is a diagram showing a portion of a cross section of a display according to a third embodiment of the present disclosure.
FIG. 11 is a plan view of the light emitting apparatus of the display of FIG. 10.
FIG. 12 is an enlarged view of part C of FIG. 11.
FIG. 13 is a plan view of a light emitting apparatus of a display according to a fourth embodiment of the present disclosure.
FIG. 14 is an enlarged view of part D of FIG. 13.
FIG. 15 is a plan view of a light emitting apparatus of a display according to a fifth embodiment of the present disclosure.
FIG. 16 is a plan view of a light emitting apparatus of a display according to a sixth embodiment of the present disclosure.

### BEST MODE FOR CARRYING OUT THE INVENTION

Hereinafter, specific embodiments for implementing a spirit of the present disclosure will be described in detail with reference to the drawings. In describing the present disclosure, detailed descriptions of known configurations or functions may be omitted to clarify the present disclosure.

Further, when an element is referred to as being 'connected' to, 'supported' by, or 'supplied' to, another element, it should be understood that the element may be directly connected to, supported by, or supplied to another element, but that other elements may exist in the middle.

The terms used in the present disclosure are only used for describing specific embodiments, and are not intended to limit the present disclosure. Singular expressions include plural expressions unless the context clearly indicates otherwise.

Further, in the present disclosure, it is to be noted that expressions, such as the upper side, are described based on the illustration of drawings, but may be modified if directions of corresponding objects are changed. For the same reasons, some components are exaggerated, omitted, or schematically illustrated in the accompanying drawings, and the size of each component does not fully reflect the actual size.

Further, terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added.

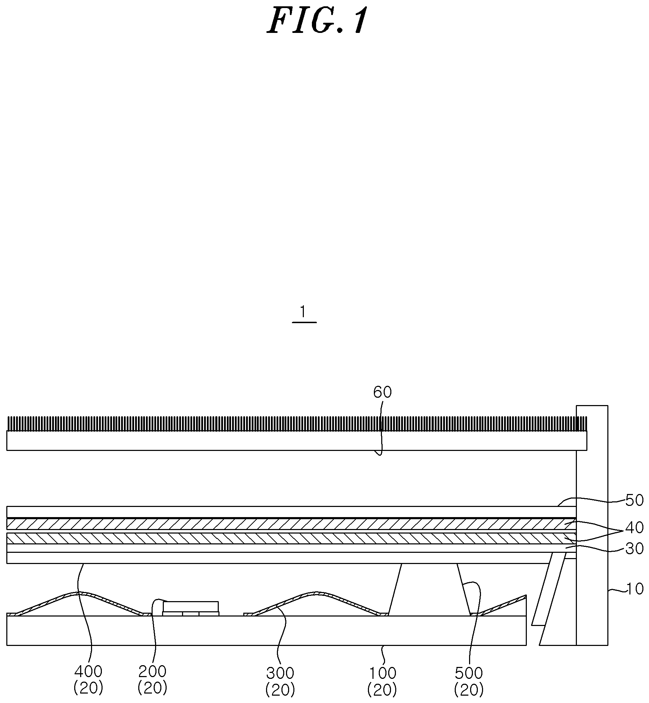

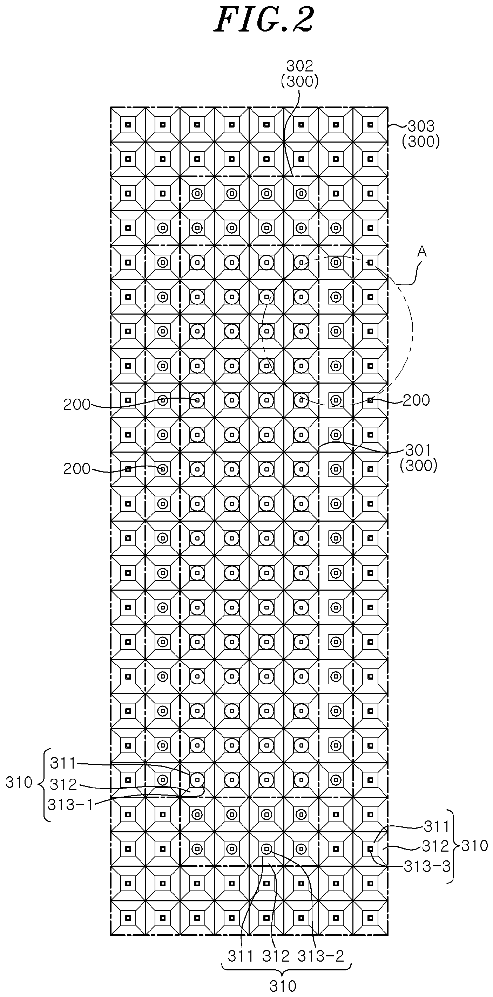

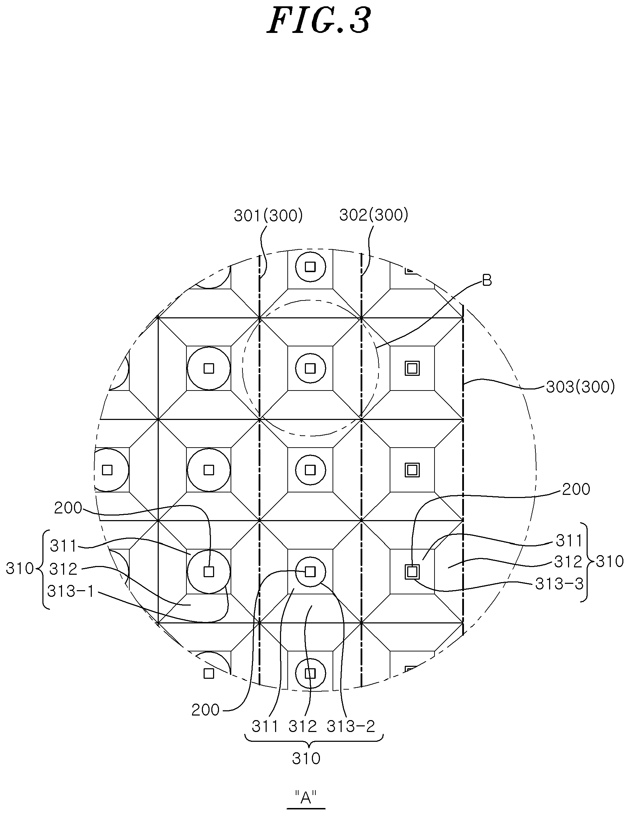

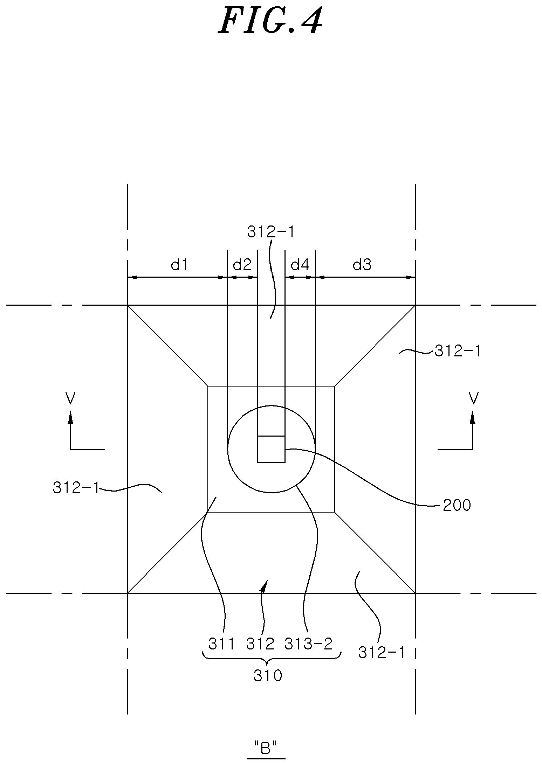

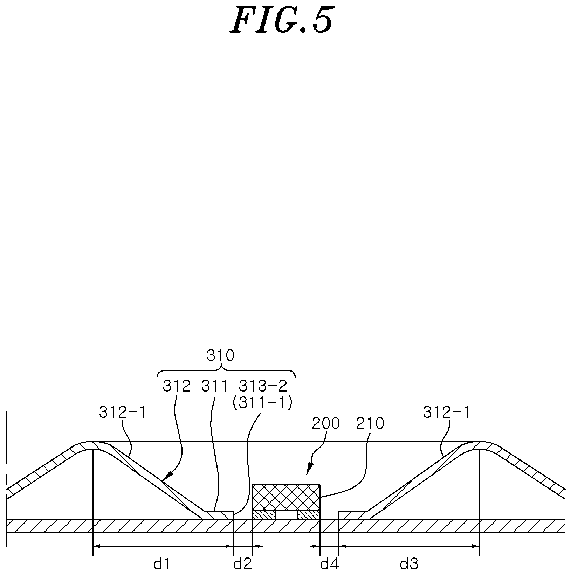

Hereinafter, the specific configuration of a display 1 according to a first embodiment of the present disclosure will be described with reference to FIGS. 1 to 5. The display 1 may display characters, symbols, images, or videos. The display 1 may include a frame 10, a light emitting apparatus 20, a phosphor layer 30, a film 40, a protective layer 50, and a panel 60.

The frame 10 may support the light emitting apparatus 20, the phosphor layer 30, the film 40, the protective layer 50, and the panel 60. In addition, the frame 10 may form the outer shape of the display 1. The light emitting apparatus 20, the phosphor layer 30, the film 40, the protective layer 50, and the panel 60 may be disposed inside the frame 10.

The light emitting apparatus 20 may emit light. The light emitting apparatus 20 can perform surface-emitting. In other words, the light emitting apparatus 20 may emit light from at least a portion of one surface. For example, the light emitting apparatus 20 may emit light from at least a portion of an upper surface. The light emitting apparatus 20 may include a circuit board 100, a light emitting device 200, a reflective sheet 300, a diffusion plate 400, and a spacer 500.

An electric circuit (not shown) may be disposed on the circuit board 100. A plurality of light emitting devices 200 may be arranged on the circuit board 100 to be connected to the electric circuit. The electric circuit of the circuit board 100 may be electrically connected to a light emitting diode chip 210 included in each of the plurality of light emitting devices 200, which will be described later, and supply electricity to the light emitting diode chip 210. For example, the circuit board 100 may be a printed circuit board (PCB) on which the electric circuit is printed.

The circuit board 100 may be provided in plural pieces. At least a portion of the plurality of light emitting devices 200 may be connected to each of the plurality of circuit boards 100. In other words, a predetermined number of light emitting devices 200 may be connected to each of the plurality of circuit boards 100. A predetermined number of light emitting devices 200 connected to each of the plurality of circuit boards 100 may be connected in series or in parallel with each other. In addition, the plurality of circuit boards 100 may be connected in parallel with each other. Further, a predetermined number of light emitting devices 200 connected to each of the plurality of circuit boards 100 may be connected in parallel with each other. In addition, the plurality of circuit boards 100 may be connected in series with each other. Further, the plurality of light emitting devices 200 may independently emit light or adjust light intensity in predetermined numbers.

The light emitting device 200 may emit light. A plurality of light emitting devices 200 may be provided. The plurality of light emitting devices 200 may be connected to the circuit board 100. A plurality of light emitting devices 200 may be connected to the circuit board 100 to be arranged in a grid pattern. In other words, the plurality of light emitting devices 200 may be connected to the circuit board 100 to be arranged in a predetermined number of rows and a predetermined number of columns. A light emitting device 200 accommodated in a reflective cell 310 disposed in a first zone 301 included in the reflective sheet 300, which will be described later, may have a different beam angle, luminous intensity, or peak wavelength from a light emitting device 200 accommodated in a reflective cell 310 disposed in a third zone 303 included in the reflective sheet 300, which will be described later. The light emitting device 200 may include a light emitting diode chip 210. The light emitting diode chip 210 may be connected to the electric circuit of the circuit board 100 and may emit light by electricity supplied through the electric circuit.

The reflective sheet 300 may reflect light emitted from the plurality of light emitting devices 200. The reflective sheet 300 may include a first zone 301, a second zone 302, and a third zone 303. The first zone 301 may include a central portion of the reflective sheet 300. In addition, the second zone 302 may be disposed closer to an edge of the reflective sheet 300 than the first zone 301. In addition, the third zone 303 may be disposed closer to the edge of the reflective sheet 300 than the second zone 302. In other words, the first zone 301, the second zone 302, and the third zone 303 may be arranged from the central portion of the reflective sheet 300 toward the edge.

A plurality of reflective cells 310 may be formed in the reflective sheet 300. In addition, a plurality of light emitting devices 200 may be accommodated in each of the plurality of reflective cells 310, so that the light emitted from the light emitting devices 200 may be reflected by the reflective cells 310. The plurality of reflective cells 310 may be arranged in a grid pattern. In other words, the plurality of reflective cells 310 may be formed in the reflective sheet 300 so as to be arranged in a predetermined number of rows and a predetermined number of columns. The reflective cells 310 may have a shape that is symmetrical with respect to the horizontal or vertical direction when viewed from above. For example, the reflective cells 310 may have an approximately rectangular or square shape when viewed from above. In addition, the plurality of reflective cells 310 may be arranged to be symmetrical with respect to the horizontal and vertical directions when viewed from above. For example, the plurality of reflective cells 310 may be arranged in a rectangular or square shape when viewed from above. The reflection area of the plurality of reflective cells 310 may increase as they are disposed closer to the edge of the reflective sheet 300. The reflective cell 310 may include a device arrangement portion 311, a wall portion 312, and a low-reflection pattern 313.

The light emitting device 200 may be placed in the device arrangement portion 311. An element placement hole 311-1 through which at least a portion of the light emitting device 200 may pass to be placed may be formed in the device arrangement portion 311. The element placement hole 311-1 may be identical to the low-reflection pattern 313, as will be described later.

The device arrangement portion 311 may have a shape that is symmetrical with respect to the horizontal and vertical directions when viewed from above. For example, the device arrangement portion 311 may have an overall rectangular shape or square shape when viewed from above. The shapes of the device arrangement portions 311 arranged in the first zone 301 and the second zone 302 of the reflective sheet 300 may be different from the shapes of the device arrangement portions 311 arranged in the third zone 303 of the reflective sheet 300. As described below, the shapes of the low-reflection patterns 313 arranged in the device arrangement portions 311 in the first zone 301 and the second zone 302 may be different from the shapes of the low-reflection patterns 313 arranged in the device arrangement portions 311 in the third zone 303. In addition, the shapes of the device arrangement portions 311 arranged in the first zone 301 and the second zone 302 of the reflective sheet 300 may be different from the shapes of the device arrangement portions 311 arranged in the third zone 303 of the reflective sheet 300. The low-reflection pattern 313 may be arranged in the device arrangement portion 311.

The wall portion 312 may form a boundary with the neighboring reflective cell 310. The wall portion 312 may have a shape that is symmetrical with respect to the horizontal and vertical directions when viewed from above. For example, the wall portion 312 may have an overall rectangular or square shape when viewed from above. The wall portion 312 may have an inclined surface 312-1 that is inclined to the device arrangement portion 311. In addition, an upper surface or height of the wall portion 312 may be higher than that of the light emitting device 200.

The wall portions 312 of the reflective cells 310 arranged in the first zone 301 and the second zone 302 may have a shape or area different from those of a first low-reflection pattern 313-1, to be described later, included in the reflective cell 310 of the first zone 301 and a second low-reflection pattern 313-2, to be described later, included in the reflective cell 310 in the second zone 302. For example, the wall portions 312 of the reflective cells 310 arranged in the first zone 301 and the second zone 302 may have an overall rectangular or square shape when viewed from above. In addition, the first low-reflection pattern 313-1 of the reflective cell 310 in the first zone 301 and the second low-reflection pattern 313-2 of the reflective cell 310 in the second zone 302 may have a circular shape. Further, the wall portions 312 of the reflective cells 310 arranged in the third zone 303 may have a shape corresponding to the shape of a third low-reflection pattern 313-3, to be described later, included in the reflective cell 310 of the third zone 303. For example, the wall portions 312 of the reflective cells 310 arranged in the third zone 303 may have an overall rectangular shape or square shape when viewed from above. In addition, the third low-reflection pattern 313-3 of the reflective cell 310 in the third zone 303 may have a rectangular or square shape.

The low-reflection pattern 313 can reduce the reflection area of the reflective cell 310. The low-reflection pattern 313 may be disposed in the device arrangement portion 311 around the light emitting device 200. The low-reflection pattern 313 may be disposed as holes formed in the device arrangement portion 311 around the light emitting device 200 or as a low-brightness pattern in the device arrangement portion 311 around the light emitting device 200. The low-reflection pattern 313 may have a lower light reflectance than that of the reflective sheet 300. When the low-reflection pattern 313 is disposed in holes formed in the device arrangement portion 311 around the light emitting device 200, the low-reflection pattern 313 may serve as the element arrangement hole 311-1. In other words, the low-reflection pattern 313 and the element placement hole 311-1 may be the same.

The plurality of low-reflection patterns 313 may have a relatively smaller size for the pattern disposed closer to the edge of the reflective sheet 300 compared to other patterns. Alternatively, the plurality of low-reflection patterns 313 may have a lower saturation or brightness for the pattern disposed closer to the edge of the reflective sheet 300. The plurality of low-reflection patterns 313 may become smaller in size, have lower saturation, or have lower brightness as they are disposed closer to the edge of the reflective sheet 300. The plurality of low-reflection patterns 313 may also be achromatic. In addition, in the plurality of reflective cells 310, a device area ratio, which is a ratio of a light-emitting area of the light emitting device 200 to an area of the low-reflection pattern 313, may become larger as they are disposed closer to the edge of the reflective sheet 300. Further, the sum of the areas of the low-reflection patterns 313 of the plurality of reflective cells 310 in the edge row may be smaller than the sum of the areas of the low-reflection patterns 313 of the plurality of reflective cells 310 in the row passing through the center of the reflective sheet 300. In addition, in the plurality of reflective cells 310, a distance d1 between the edge of the wall portion 312 and the edge of the low-reflection pattern 313 may increase as they are disposed closer to the edge of the reflective sheet 300. In addition, in the plurality of reflective cells 310, a distance d2 between the edge of the light emitting device 200 and the edge of the low-reflection pattern 313 may decrease as they are disposed closer to the edge of the reflective sheet 300. The value of d1/(d1+d2) value for the first low-reflection pattern 313-1 may be smaller than the value of d1/(d1+d2) for the second low-reflection pattern 313-2. Alternatively, the value of d1/(d1+d2) for the first low-reflection pattern 313-1 may be smaller than the value of d1/(d1+d2) for the third low-reflection pattern 313-3. The value of d1/(d1+d2) for the second low-reflection pattern 313-2 may be smaller than the value of d1/(d1+d2) for the third low-reflection pattern 313-3. On the opposite side of the light emitting device 200, a distance d3 between the edge of the wall portion 312 and the edge of the low-reflection pattern 313 and a distance d4 between the edge of the light emitting device 200 and the edge of the low-reflection pattern 313 may be formed, and d1/(d1+d2) may have a different value from d3/(d3+d4). In addition, d2 and d4 may have different values. The plurality of low-reflection patterns 313 may include the first low-reflection pattern 313-1, the second low-reflection pattern 313-2, and the third low-reflection pattern 313-3.

The first low-reflection pattern 313-1 may be included in the reflective cells 310 arranged in the first zone 301. The shape of the first low-reflection pattern 313-1 may be different from the shape of the light emitting device 200. For example, the first low-reflection pattern 313-1 may have a circular shape, and the shape of the light emitting device 200 may have a rectangular or square shape.

The second low-reflection pattern 313-2 may be included in the reflective cells 310 arranged in the second zone 302. In other words, the second low-reflection pattern 313-2 may be included in the reflective cells 310 arranged around the reflective cells 310 including the first low-reflection pattern 313-1. The first zone 301 including the first low-reflection pattern 313-1 may be surrounded by the second zone 302 including the second low-reflection pattern 313-2. The area of the second low-reflection pattern 313-2 may be smaller than the area of the first low-reflection pattern 313-1. In addition, the curvature of the second low-reflection pattern 313-2 may be larger than the curvature of the first low-reflection pattern 313-1. In addition, the radius of curvature of the second low-reflection pattern 313-2 may be smaller than the radius of curvature of the first low-reflection pattern 313-1. The shape of the second low-reflection pattern 313-2 may be different from the shape of the light emitting device 200. For example, the second low-reflection pattern 313-2 may have a circular shape, and the shape of the light emitting device 200 may have a rectangular or square shape.

The third low-reflection pattern 313-3 may be included in the reflective cells 310 arranged in the third zone 303. In other words, the third low-reflection pattern 313-3 may be included in the reflective cells 310 arranged around the reflective cells 310 including the second low-reflection pattern 313-2. The first zone 301 including the first low-reflection pattern 313-1 may be surrounded by the third zone 303 including the third low-reflection pattern 313-3. Alternatively, the second zone 302 including the second low-reflection pattern 313-2 may be surrounded by the third zone 303 including the third low-reflection pattern 313-3. The area of the third low-reflection pattern 313-3 may be smaller than the area of the second low-reflection pattern 313-2. In addition, the curvature or curvature radius of the third low-reflection pattern 313-3 may be different from the curvature of the first low-reflection pattern 313-1 and the curvature or curvature radius of the second low-reflection pattern 313-2. The shape of the third low-reflection pattern 313-3 may have a shape corresponding to the shape of the light emitting device 200. For example, the third low-reflection pattern 313-3 may have a rectangular or square shape.

The diffusion plate 400 can diffuse light emitted from the plurality of light emitting devices 200. The diffusion plate 400 may be disposed above the plurality of light emitting devices 200 and the reflective sheet 300.

The spacer 500 may be disposed between the diffusion plate 400 and the reflective sheet 300 so that the diffusion plate 400 and the reflective sheet 300 maintain a predetermined distance. The spacer 500 may have a columnar or cone shape and may have a circular upper surface when viewed from above. The side surface of the spacer 500 may be light reflective. The spacer 500 is not necessarily required, and the spacer 500 may not be disposed depending on the shape and size of the light emitting apparatus 20.

The phosphor layer 30 may include phosphors or quantum dots (QDs) (not shown) that emit light of a converted color when light is incident, thereby implementing white light. The phosphor layer 30 may be disposed above the diffusion plate 400 of the light emitting apparatus 20.

However, the present disclosure is not necessarily limited to the above, and in another embodiment, the phosphor layer 30 may be disposed to correspondingly cover each light emitting device 200. Accordingly, the phosphor layer 30 may be arranged in plural pieces and spaced apart by a predetermined interval.

Alternatively, in another embodiment, a light blocking layer may be disposed above the plurality of phosphor layers 30 that are spaced apart from each other. A plurality of light blocking layers may be arranged to correspond to the respective phosphor layers 30. Alternatively, a plurality of light blocking layers may be arranged to correspond to each light emitting device 200. The light blocking layer may include a light-reflective material and may reflect light generated by the light emitting device 200 from the upper surface of the light emitting device 200 to change the emission path of the light. When the light blocking layer is disposed, the position of the upper surface of the light blocking layer may be lower than the upper surface of the wall portion 312 of the reflective sheet 300. Therefore, a larger amount of light can be reflected by the reflective sheet 300.

The film 40 may be disposed above the light emitting device 200 to refract or focus light emitted from the light emitting device 200 to increase the luminance of light on the surface of the backlight. The film 40 may be formed as a single layer or as two or more layers. The film 40 may include a prismatic sheet.

The protective layer 50 may be disposed between and the film 40 and the panel 60, which will be described later, to prevent the material contained in the panel 60 from diffusing into the film 40. In addition, the protective layer 50 may spread the viewing angle adjusted by the film 40 to widen the viewing angle, so that light can be uniformly distributed in the light emitting apparatus 20.

The panel 60 may be disposed above the protective layer 50 so that light passing through the protective sheet 50 can be incident on the panel 60 and emitted through the panel 60.

As described above, the light emitting apparatus 20 of the display 1 according to the first embodiment of the present disclosure can be configured such that the reflective sheet 300 increases the degree of light reflection toward the edge. Accordingly, the light emitting apparatus 20 of the display 1 according to the first embodiment of the present disclosure can improve the surface light emission effect.

Meanwhile, in addition to such configurations, according to a second embodiment of the present disclosure, in the reflective sheet 300, a plurality of light emitting devices 200 may be arranged in one reflective cell 310.

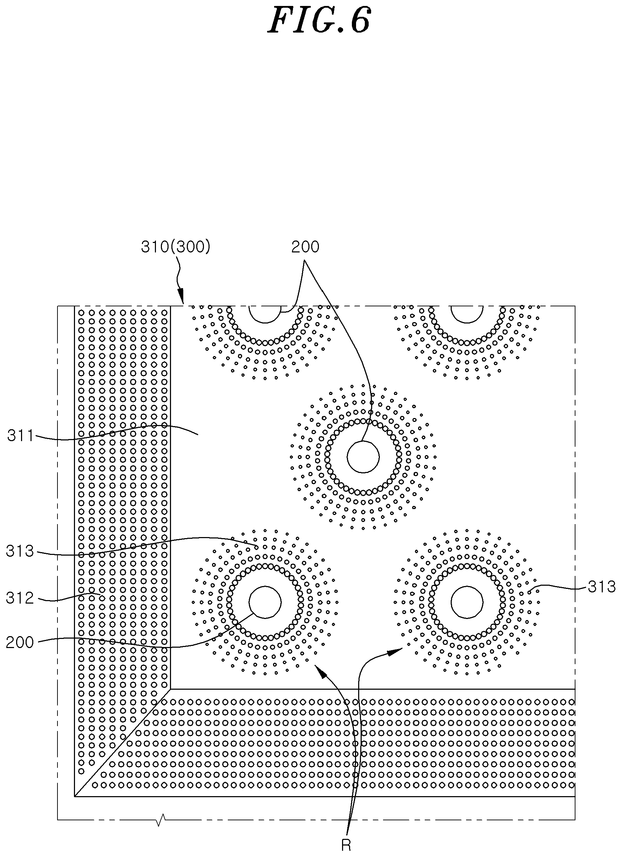

Hereinafter, the second embodiment will be described with reference to FIGS. 6 to 9. In describing the second embodiment of the present disclosure, there is a difference from the above-described embodiments in that a plurality of light emitting devices 200 are arranged in one reflective cell 310 in the reflective sheet 300, so this difference will be mainly described, and the same description and reference numerals will be referred to the above-described embodiments.

Referring to FIG. 6, a plurality of light emitting devices 200 may be arranged in one reflective cell 310 in the reflective sheet 300.

In addition, a plurality of low-reflection patterns 313 may be arranged in respective neighboring regions of at least some of the plurality of light emitting devices 200. The plurality of low reflection patterns 313 may have a relatively smaller size for the pattern disposed farther from the edge of the reflective sheet 300 compared to other patterns. Alternatively, the plurality of low-reflection patterns 313 may have a lower saturation or brightness for the pattern disposed closer to the edge of the reflective sheet 300. The plurality of low-reflection patterns 313 may decrease in size, saturation, or brightness as they are disposed farther away from the light emitting device 200. In addition, the distance between the plurality of low-reflection patterns 313 may increase as the low-reflection patterns 313 are disposed farther away from the light emitting device 200. Further, one of the plurality of low-reflection patterns 313 may be smaller in size than another one of the plurality of low-reflection patterns 313.

Meanwhile, regions adjacent to at least some of the plurality of light emitting devices 200 may be named a pattern arrangement region R. The pattern arrangement region R may have a circular shape as shown in FIG. 6. The plurality of low-reflection patterns 313 arranged in one pattern arrangement region R may be disposed at different distances from each other depending on the arrangement positions. For example, the distance between the low-reflection patterns 313 disposed relatively adjacent to the light emitting device 200 among the plurality of low-reflection patterns 313 may be smaller than the distance between the low-reflection patterns 313 disposed relatively farther from the light emitting device 200 among the plurality of low-reflection patterns 313. As a more detailed example, the separation distance between the plurality of low-reflection patterns 313 arranged in one pattern arrangement region R may increase as they are disposed farther away from the light emitting device 200.

One or more of the plurality of low-reflection patterns 313 arranged in the pattern arrangement region R may have different sizes. For example, among the low-reflection patterns 313 arranged in one pattern arrangement region R, the size of the low-reflection pattern 313 disposed relatively closer to the light emitting device 200 may be larger than the size of the low-reflection pattern 313 disposed relatively farther away from the light emitting device 200. As a more detailed example, the plurality of low-reflection patterns 313 arranged in one pattern arrangement region R may become smaller in size as they are disposed farther away from the light emitting device 200.

The plurality of low-reflection patterns 313 arranged in one pattern arrangement region R may be arranged at different densities depending on the arrangement position. For example, the density of the low-reflection pattern 313 disposed relatively closer to the light emitting device 200 among the plurality of low-reflection patterns 313 may be greater than the density of the low-reflection pattern 313 disposed relatively farther from the light emitting device 200 among the plurality of low-reflection patterns 313. Alternatively, the low-reflection pattern 313 surrounding a single light emitting device 200 may have different brightness, different sizes, or different saturation in an area of the low-reflection pattern 313 disposed closest to the single light emitting device 200 and in another area of the low-reflection pattern 313 disposed farthest from the single light emitting device 200.

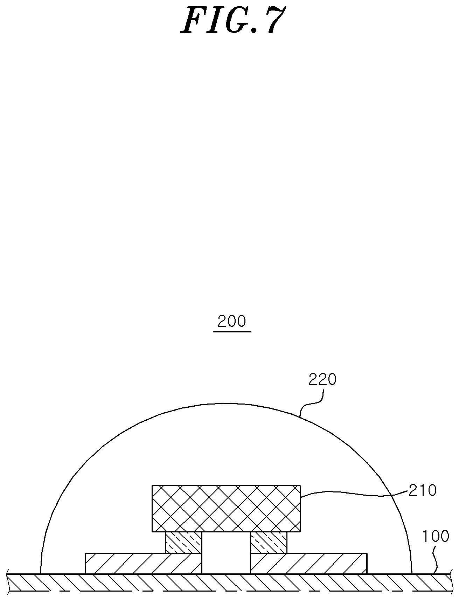

Referring to FIG. 7, the light emitting device 200 may include a light emitting diode chip 210 and a light transmitting portion 220. The light emitting diode chip 210 may be connected to a circuit board 100. In addition, the light transmitting portion 220 may cover the light emitting diode chip 210. The light emitting diode chip 210 may be connected to an electric circuit of the circuit board 100 and may emit light by electricity supplied through the electric circuit. The light transmitting portion 220 may cover the light emitting diode chip 210 so that the light emitting diode chip 210 is sealed from the outside, thereby protecting the light emitting diode chip 210. In addition, the light transmitting portion 220 may act as a lens that guides a path of light emitted from the light emitting diode chip 210 in a predetermined direction.

The light emitting device 200 may include a plurality of light emitting devices 200. The plurality of light emitting devices 200 may be electrically connected to the electrical circuit of the circuit board 100. The plurality of light emitting devices 200 may be disposed in the main region 3100 included in the reflective sheet 300, which will be described later. The light emitting device 200 disposed at the center of the main region 3100 of the reflective sheet 300 may have a different beam angle, luminous intensity, and peak wavelength from the light emitting device 200 disposed at the edge of the main region 3100.

The light transmitting portion 220 may function as a lens that guides the path of light emitted from the light emitting diode chip 210 in a predetermined direction. The light transmitting portion 220 may additionally include a wavelength conversion material. Therefore, the light generated from the light emitting diode chip 210 can be converted by the wavelength conversion material and emitted at a different wavelength. The light transmitting portion 220 may be molding, resin, lens, etc.

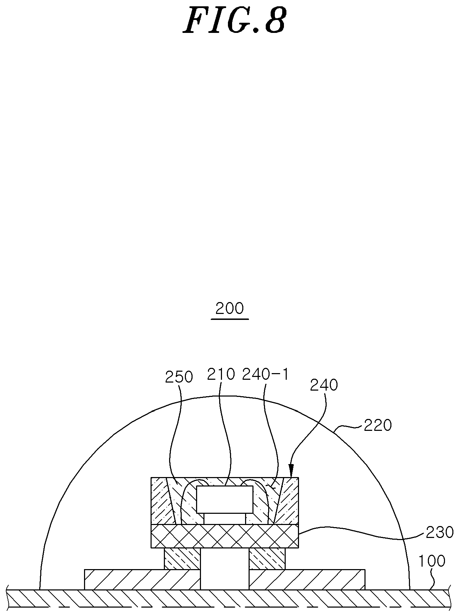

Referring to FIG. 8, the light emitting device 200 may further include a package substrate 230, a chip arrangement layer 240, and a phosphor layer 250. The package substrate 230 may be connected to the circuit board 100. The chip arrangement layer 240 may be disposed above the package substrate 230, and may have a chip arrangement space 240-1 formed therein. The chip arrangement space 240-1 may be formed such that the area of a cross-section perpendicular to an up-down direction increases as it goes upward. In other words, the sides of the chip arrangement space 240-1 may be inclined to form an obtuse angle with a horizontal bottom. The phosphor layer 250 may be disposed in the chip arrangement space 240-1. The light emitting diode chip 210 may be disposed in the phosphor layer 250 to be connected to the package substrate 230. For example, the light emitting diode chip 210 may be connected to the package substrate 230 by wires or the like. The light transmitting portion 220 may cover the package substrate 230, the chip arrangement layer 240, and the phosphor layer 250.

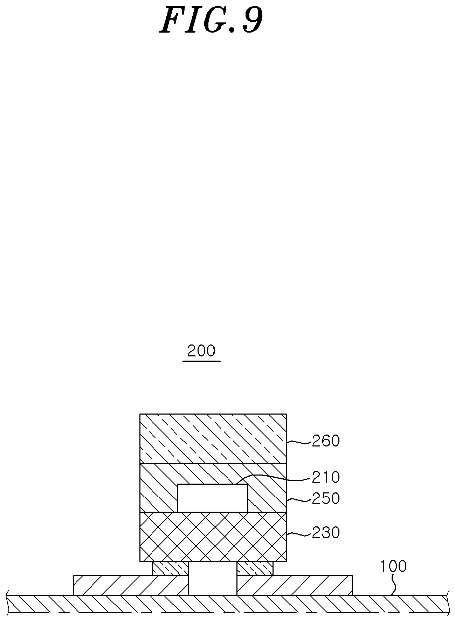

Referring to FIG. 9, the light emitting device 200 may further include a reflective layer 260. The phosphor layer 250 may be disposed above the package substrate 230. In addition, the light emitting diode chip 210 may be disposed in the phosphor layer 250. Further, the reflective layer 260 may be disposed above the phosphor layer 250.

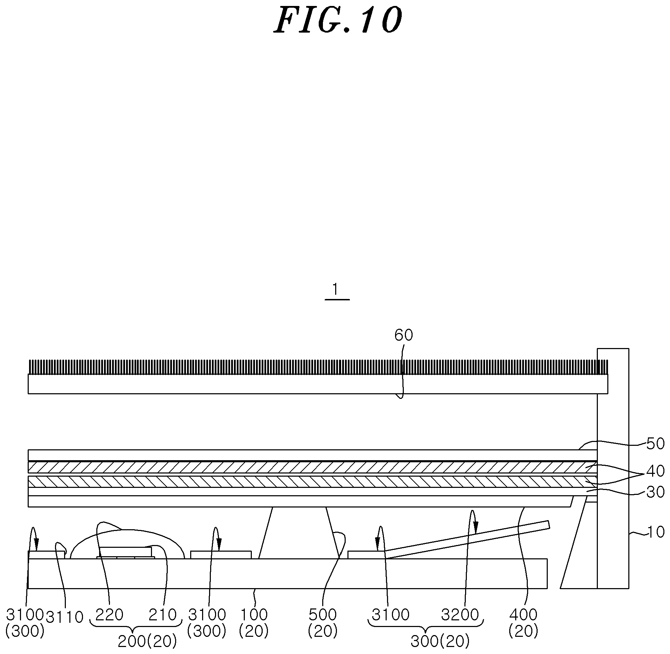

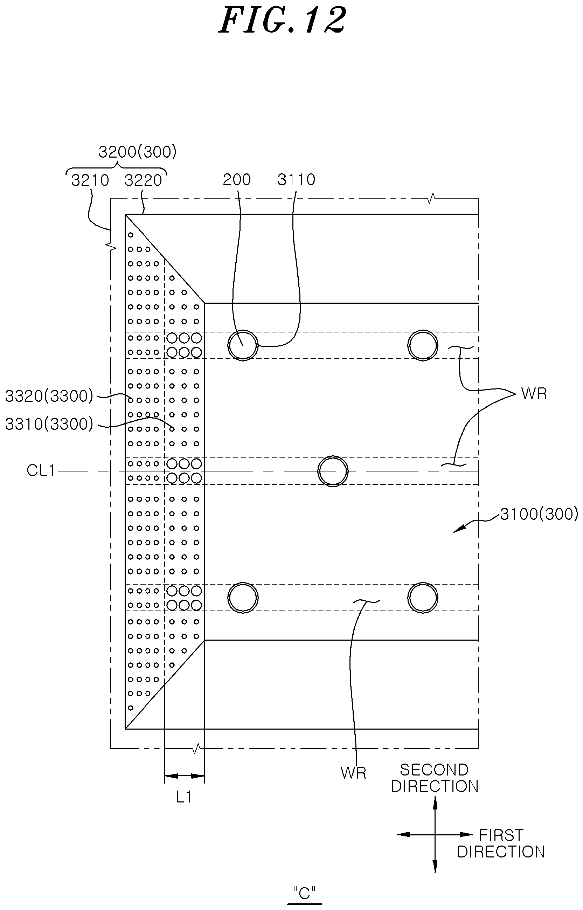

Hereinafter, the specific configuration of a display 1 according to a third embodiment of the present disclosure will be described with reference to FIGS. 10 to 12. The display 1 may display characters, symbols, images, or videos. The display 1 may include a frame 10, a light emitting apparatus 20, a phosphor layer 30, a film 40, a protective layer 50, and a panel 60.

Referring to FIG. 10, the frame 10 may support the light emitting apparatus 20, the phosphor layer 30, the film 40, the protective layer 50, and the panel 60. In addition, the frame 10 may form the outer shape of the display 1. The light emitting apparatus 20, the phosphor layer 30, the film 40, the protective layer 50, and the panel 60 may be disposed inside the frame 10.

The light emitting apparatus 20 may emit light. The light emitting apparatus 20 can perform surface-emitting. In other words, the light emitting apparatus 20 may emit light from at least a portion of one surface. For example, the light emitting apparatus 20 may emit light from at least a portion of an upper surface. The light emitting apparatus 20 may include a circuit board 100, a light emitting device 200, a reflective sheet 300, a diffusion plate 400, and a spacer 500.

An electric circuit (not shown) may be disposed on the circuit board 100. A plurality of light emitting devices 200 may be arranged on the circuit board 100 to be connected to the electric circuit. The electric circuit of the circuit board 100 may be electrically connected to a light emitting diode chip 210 included in each of the plurality of light emitting devices 200, which will be described later, and supply electricity to the light emitting diode chip 210. For example, the circuit board 100 may be a printed circuit board (PCB) on which the electric circuit is printed.

The circuit board 100 may be provided in plural pieces. At least a portion of the plurality of light emitting devices 200 may be connected to each of the plurality of circuit boards 100. In other words, a predetermined number of light emitting devices 200 may be connected to each of the plurality of circuit boards 100. The plurality of circuit boards 100 may extend in a first direction and be arranged to be spaced apart from each other in a second direction that is different from (or intersects) the first direction. For example, the first direction may be a transverse direction and the second direction may be a longitudinal direction. In addition, the circuit board 100 may have a bar shape extending in the first direction.

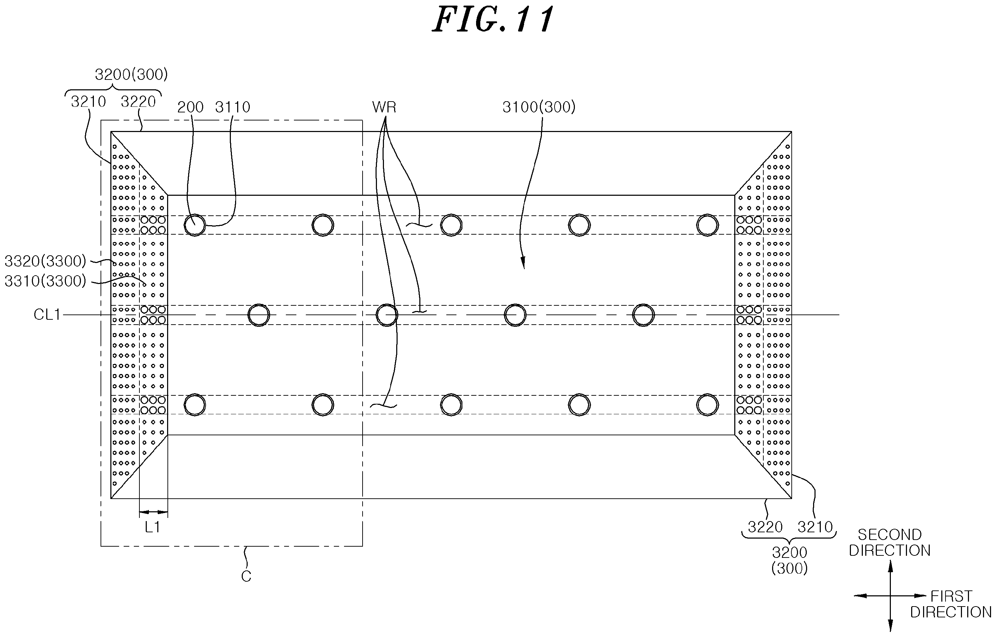

Referring to FIG. 11, the reflective sheet 300 may reflect light emitted from the plurality of light emitting devices 200 and may accommodate the plurality of light emitting devices 200. The reflective sheet 300 may have a rectangular shape with a predetermined length in each of the first and second directions, and the length in the first direction may be longer than the length in the second direction. The reflective sheet 300 may include a main region 3100, a side region 3200, and a low-reflection pattern 3300.

The main region 3100 may include a central portion of the reflective sheet 300. The plurality of light emitting devices 200 may be disposed in the main region 3100. An element arrangement hole 3110 is formed in the main region 3100, and at least a portion of the light emitting device 200 may pass through the element arrangement hole 3110 to be disposed. At least a portion of the plurality of light emitting devices 200 in the main region 3100 may be disposed in an area where a first direction arrangement region WR extending in a first direction and the main region 3100 of the reflective sheet 300 overlap. For example, in the main region 3100, at least a portion of the plurality of light emitting devices 200 may be disposed in an area where the main region 3100 overlaps with the first direction arrangement region WR extending in the transverse direction.

The first direction arrangement region WR may be defined as a virtual area extending along the first direction in the main region 3100 and the side region 3200, to be described later, of the reflective sheet 300 while having a width equal to the length in the second direction of at least one light emitting device 200. For example, the first direction arrangement region WR has a width equal to the longitudinal length of at least one light emitting device 200, and may be defined as a virtual area extending along the transverse direction in the main region 3100 of the reflective sheet 300 and a first side 3210.

The first direction arrangement region WR may be provided in plural numbers or as a plurality of regions. In addition, the plurality of first direction arrangement regions WR are spaced apart from each other in the second direction, and at least a portion of the plurality of light emitting devices 200 may be placed in overlapping areas of plurality of first direction arrangement regions WR and the main region 3100. For example, the plurality of first direction arrangement regions WR are spaced apart from each other in the longitudinal direction, and at least a portion of the plurality of light emitting devices 200 can be placed in overlapping area of the plurality of first direction arrangement regions WR and the main region 3100.

The side region 3200 may be arranged around the main region 3100 at an angle with respect to the main region 3100. The side region 3200 may be arranged at an incline so that the height increases as it is spaced apart from the main region 3100. In other words, the side region 3200 may be inclined upward with respect to the main region 3100. The side region 3200 may include a first side portion 3210 and a second side portion 3220.

The first side portion 3210 may be disposed on both sides of the main region 3100 in the first direction. In other words, a plurality of first side portions 3210 may be provided, and the main region 3100 may be disposed between the plurality of first side portions 3210, and one first side portion 3210, the main region 3100 and the other first side part 3210 may be sequentially arranged along the first direction. For example, one first side portion 3210, the main region 3100, and the other first side portion 3210 may be sequentially arranged along the transverse direction.

The second side portion 3220 may be disposed on both sides of the main region 3100 in the second direction. In other words, a plurality of second side portions 3220 may be provided, and the main region 3100 may be disposed between the plurality of second side portions 3220, and one second side portion 3220, the main region 3100 and the other second side part 3220 may be sequentially arranged along the second direction. For example, one second side portion 3220, the main region 3100, and the other second side portion 3220 may be sequentially arranged along the longitudinal direction. The reflective area of the second side portion 3220 may be larger than that of the first side portion 3210.

The low-reflection pattern 3300 may have a lower light reflectance than a portion of the reflective sheet 300 where the low-reflection pattern 3300 is not disposed. A plurality of low-reflection patterns 3300 may be provided, and the plurality of low-reflection patterns 3300 may be disposed in the side region 3200. The low-reflection pattern 3300 may be arranged with a hole formed in the side region 3200 or may be arranged in color. Alternatively, the low-reflection pattern 3300 may have a different brightness or color than other areas. At least a portion of the plurality of low-reflection patterns 3300 may be disposed in an area where the first direction arrangement region WR and the side region 3200 overlap. In addition, another portion of the plurality of low-reflection patterns 3300 may be disposed in the side region 3200 other than the first direction arrangement region WR. In addition, at least a portion of the low-reflection pattern 3300 disposed in the area where the first direction arrangement region WR and the side region 3200 overlap may be larger in size, may be arranged more densely, or may have relatively closer spacing between the low-reflection patterns 3300 than the low-reflection patterns 3300 disposed in the side region 3200 other than the first direction arrangement region WR.

For example, at least a portion of the plurality of low-reflection patterns 3300 may be disposed in an area where the first direction arrangement region WR and the first side portion 3210 overlap in the first side portion 3210. In addition, another portion of the plurality of low-reflection patterns 3300 may be disposed in the first side portion 3210 other than the first direction arrangement region WR. In addition, at least a portion of the low-reflection pattern 3300 disposed in the area where the first direction arrangement region WR and the first side portion 3210 overlap may be larger in size, may be arranged more densely, or may be spaced relatively closer between the low-reflection patterns 3300 than the low-reflection pattern 3300 disposed in the first side portion 3210 other than the first direction arrangement region WR. The low-reflection pattern 3300 disposed in the area where the first direction arrangement region WR and the first side portion 3210 overlap in the first side portion 3210 may be called a first region inner pattern. In addition, the low-reflection pattern 3300 disposed in the first side portion 3210 other than the first direction arrangement region WR may be referred to as a first region outer pattern. In addition, at least a portion of the first region inner pattern may be larger, may be arranged more densely, or may have relatively closer spacing between the patterns than the first region outer pattern.

The plurality of low-reflection patterns 3300 may be arranged in the side region 3200 to be symmetrical with respect to a virtual first direction center line CL1 extending in the first direction while passing through the center of the reflective sheet 300. The low-reflection pattern 3300 may include a first pattern 3310 and a second pattern 3320. Alternatively, the plurality of low-reflection patterns 3300 may be arranged in the side region 3200 to be symmetrical with respect to a second direction center line CL2, perpendicular to the first direction center line CL, extending in the second direction while passing through the center of the reflective sheet 300.

The first pattern 3310 may be disposed within a predetermined first separation distance L1 from the main region 3100. For example, the first pattern 3310 may be disposed within the predetermined first separation distance L1 from the main region 3100 in the first side portion 3210. In addition, the first separation distance L1 may be equal to or less than half the length of the first side portion 3210 in the first direction. The first separation distance L1 may be less than half the length of the first side portion 3210 in the transverse direction. The number of first patterns 3310 may be smaller than the number of second patterns 3320. Alternatively, the density of the first pattern 3310 may be smaller than the density of the second pattern 3320. Accordingly, the reflectance of light in the light emitting apparatus 20 can be adjusted.

The second pattern 3320 may be disposed at a distance greater than the first separation distance L1 from the main region 3100. For example, the second pattern 3320 may be disposed at a distance greater than the first separation distance L1 from the main region 3100 in the first side portion 3210.

The size of the patterns constituting the low-reflection pattern 3300 may be smaller than the size of the light emitting device 200. Therefore, the light reflection area can be delicately controlled.

The shape of the patterns constituting the low-reflection pattern 3300 may be the same as the shape of the light transmitting portion 220. The shape of the patterns constituting the low-reflection pattern 3300 may include a curved area or have a circular shape. The patterns constituting the low-reflection pattern 3300 may have a curvature, and the curvature of the patterns may be greater than the curvature of the light transmitting portion 220. Alternatively, the patterns constituting the low-reflection pattern 3300 may have a radius of curvature, and the radius of curvature of the patterns may be smaller than the radius of curvature of the light transmitting portion 220. Therefore, the low-reflection area can be formed evenly. However, the present disclosure is not necessarily limited to the above, and the patterns constituting the low-reflection pattern 3300 may have a rectangular shape.

The diffusion plate 400 can diffuse light emitted from the plurality of light emitting devices 200. The diffusion plate 400 may be disposed above the plurality of light emitting devices 200 and the reflective sheet 300.

The spacer 500 may be disposed between the diffusion plate 400 and the reflective sheet 300 so that the diffusion plate 400 and the reflective sheet 300 maintain a predetermined distance. The spacer 500 can reflect light emitted from the light emitting device 200. The spacer 500 may have a cylindrical shape or a cone shape, and may include a material capable of reflecting light, or may have a surface coated with a material capable of reflecting light. The spacer 500 is not necessarily required, and the spacer 500 may not be disposed depending on the shape and size of the light emitting apparatus 20.

The phosphor layer 30 may include phosphors or quantum dots (QDs) (not shown) that emit light of a converted color when light is incident, thereby implementing white light. The phosphor layer 30 may be disposed above the diffusion plate 400 of the light emitting apparatus 20.

However, the present disclosure is not necessarily limited to the above, and in another embodiment, the phosphor layer 30 may be disposed to correspondingly cover each light emitting device 200. Accordingly, the phosphor layer 30 may be arranged in plural pieces and spaced apart by a predetermined interval.

Alternatively, in another embodiment, a light blocking layer may be disposed above the plurality of phosphor layers 30 that are spaced apart from each other. A plurality of light blocking layers may be arranged to correspond to the respective phosphor layers 30. Alternatively, a plurality of light blocking layers may be arranged to correspond to each light emitting device 200. The light blocking layer may include a light-reflective material and may reflect light generated by the light emitting device 200 from the upper surface of the light emitting device 200 to change the emission path of the light. When the light blocking layer is disposed, the position of the upper surface of the light blocking layer may be lower than the upper surface of the side region 3200 of the reflective sheet 300. Therefore, a larger amount of light can be reflected by the reflective sheet 300.

The film 40 may be disposed above the light emitting device 200 to refract or focus light emitted from the light emitting device 200 to increase the luminance of light on the surface of the backlight. The film 40 may be formed as a single layer or as two or more layers. The film 40 may include a prismatic sheet.

The protective layer 50 may be disposed between and the film 40 and the panel 60, which will be described later, to prevent the material contained in the panel 60 from diffusing into the film 40. In addition, the protective layer 50 may spread the viewing angle adjusted by the film 40 to widen the viewing angle, so that light can be uniformly distributed in the light emitting apparatus 20.

The panel 60 may be disposed above the protective layer 50 to control light passing through the protective layer 50.

As described above, the light emitting apparatus 20 of the display 1 according to the third embodiment of the present disclosure can reflect light emitted from the plurality of light emitting devices 200 on the reflective sheet 300, ensuring that more light is reflected evenly from the side region 3200 of the reflective sheet 300. Accordingly, the light emitting apparatus 20 of the display 1 according to the third embodiment of the present disclosure can improve the surface light emission effect.

Meanwhile, in addition to such configurations, according to a fourth embodiment of the present disclosure, at least a portion of the plurality of light emitting devices 200 may be disposed in an area where the first direction arrangement region WR, the second direction arrangement region LR extending in the second direction, and the main region 3100 overlap, and other of the plurality of low-reflection patterns 3300 may be disposed in an area where the second direction arrangement region WR and the side region 3200 overlap.

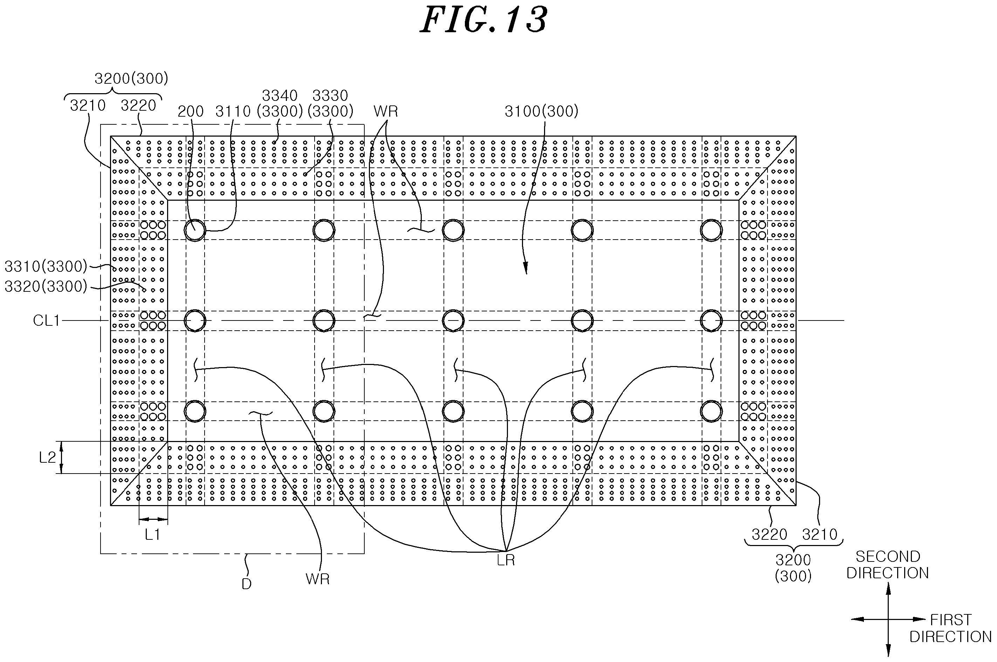

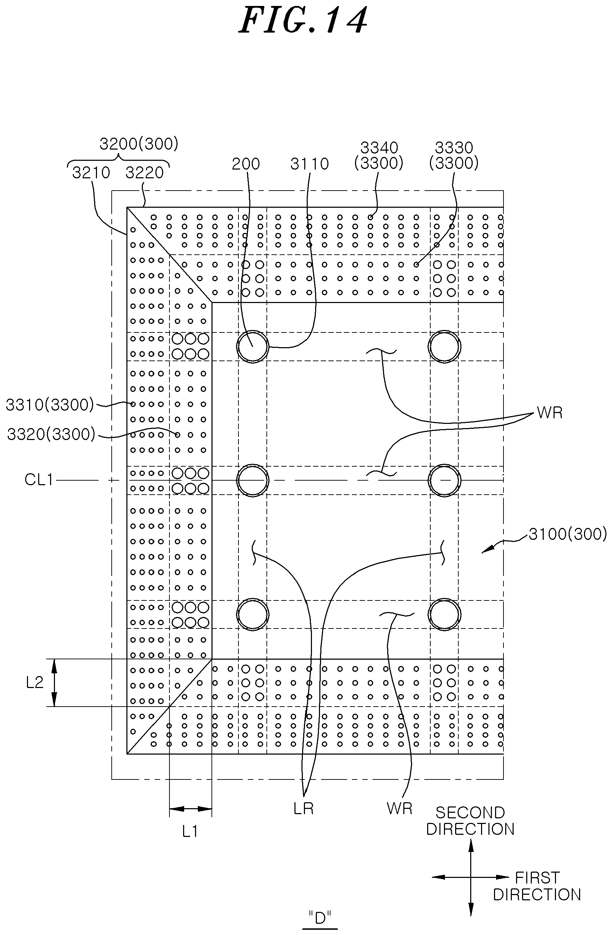

Hereinafter, the fourth embodiment will be described with reference to FIGS. 13 and 14. In describing the fourth embodiment of the present disclosure, when compared to the above-described embodiments, there is a difference in that the first direction arrangement region WR, the second direction arrangement region LR extending in the second direction, and the main region 3100 overlap, so this difference will be mainly described, and the same description and reference numerals will be referred to the above-described embodiments.

Referring to FIGS. 13 and 14, at least a portion of the plurality of light emitting devices 200 may be disposed in an area where the first direction arrangement region WR, the second direction arrangement region LR extending in the second direction, and the main region 3100 overlap. For example, in the main region 3100, at least a portion of the plurality of light emitting devices 200 may be disposed in an area where the first direction arrangement region WR extending in the transverse direction, the second direction arrangement region LR extending in the longitudinal direction, and the main region 3100 overlap.

The second direction arrangement region LR may be defined as a virtual area extending along the second direction in the main region 3100 and the side region 3200 while having a width equal to a length of at least one light emitting device 200 in the first direction. For example, the second direction arrangement region LR may be defined as a virtual area having a width equal to a transverse length of at least one light emitting device 200 and extending in the main region 3100 and the second side portion 3220 of the side region 3200 along the longitudinal direction.

The second direction arrangement region LR may be provided in plural numbers or as a plurality of regions. In addition, the plurality of second direction arrangement regions LR are spaced apart from each other in the first direction, and at least a portion of the plurality of light emitting devices 200 may be disposed in an area where the plurality of first direction arrangement regions WR, the plurality of second direction arrangement regions LR, and the main region 3100 overlap. Further, the number of second direction arrangement regions LR may be greater than the number of first direction arrangement regions WR.

Another portion of the plurality of low-reflection patterns 3300 may be disposed in an area where the second direction arrangement region LR and the side region 3200 overlap. For example, another portion of the plurality of low-reflection patterns 3300 may be disposed in an area where the second direction arrangement region LR and the second side portion 3220 overlap.

Still another portion of the plurality of low-reflection patterns 3300 may be disposed in the side region 3200 other than the second direction arrangement region LR. In addition, at least a portion of the low-reflection pattern 3300 disposed in the area where the second direction arrangement region LR and the side region 3200 overlap may be larger in size or more densely arranged than the low-reflection pattern 3300 disposed in the side region 3200 other than the second direction arrangement region LR. For example, another portion of the plurality of low-reflection patterns 3300 may be disposed in an area where the second direction arrangement region LR and the second side portion 3220 overlap in the second side portion 3220. In addition, still another portion of the plurality of low-reflection patterns 3300 may be disposed in the second side portion 3220 other than the second direction arrangement region LR. Further, at least a portion of the low-reflection pattern 3300 disposed in the area where the second direction arrangement region LR and the second side part 3220 overlap may be larger in size or more densely arranged than the low-reflection pattern 3300 disposed in the second side portion other than the second direction arrangement region LR.

The low-reflection pattern 3300 disposed in the area where the second direction arrangement region LR and the second side portion 3220 overlap in the second side portion 3220 may be called a second region inner pattern. Further, the low-reflection pattern 3300 disposed in the second side portion 3220 other than the second direction arrangement region LR may be referred to as a second region outer pattern. In addition, at least a portion of the second region inner pattern may be larger in size or more densely arranged than the second region outer pattern.

The average area of the low-reflection pattern 3300 disposed in the first side portion 3210 may be larger than the average area of the low-reflection pattern 3300 disposed in the second side portion 3220. In addition, the ratio of the sum of the areas of the low-reflection pattern 3300 disposed on the first side portion 3210 to the total area of the first side portion 3210 may be larger than the ratio of the sum of the areas of the low-reflection pattern 3300 included in the second side portion 3220 to the total area of the second side portion 3220.

The low-reflection pattern 3300 may further include a third pattern 3330 and a fourth pattern 3340. The third pattern 3330 may be disposed within a second separation distance L2 from the main region 3100 in the second side portion 3220. Further, the second separation distance L2 may be half of the length of the second side portion 3220 in the second direction. The second separation distance L2 may be half of the longitudinal length of the second side portion 3220. The number of third patterns 3330 may be smaller than the number of fourth patterns 3340. In addition, the density of the third pattern 3330 may be smaller than the density of the fourth pattern 3340. The fourth pattern 3340 may be disposed at a distance greater than the second separation distance L2 from the main region 3100 in the second side portion 3220.

Meanwhile, in addition to such configurations, according to a fifth embodiment of the present disclosure, at least a portion of the plurality of low-reflection patterns 3300 may be arranged in a convex curved shape to one side or the other side in the first direction.

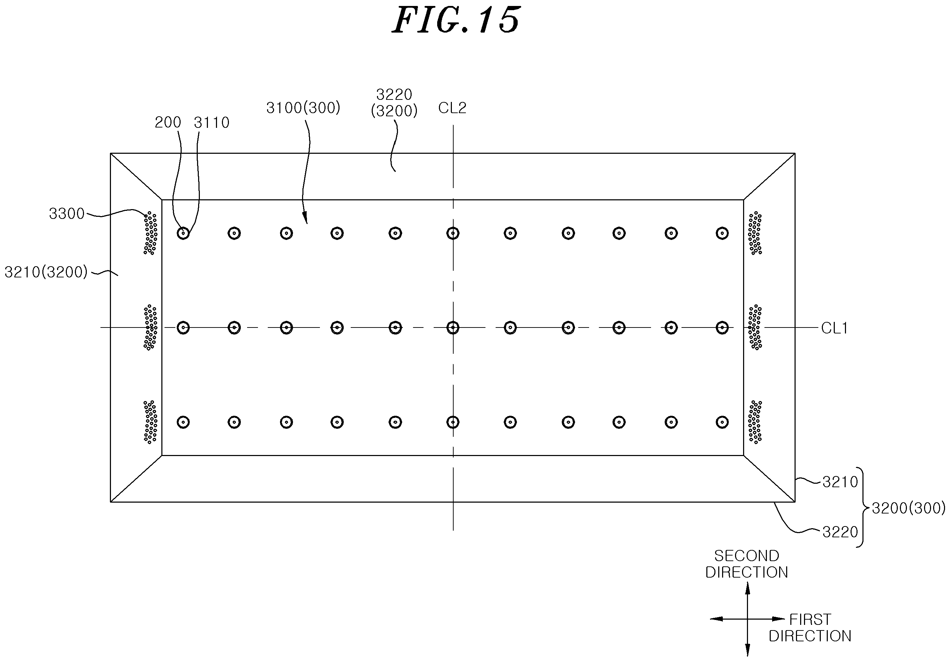

Hereinafter, the fifth embodiment will be described with reference to FIG. 15. In describing the fifth embodiment of the present disclosure, when compared to the above-described embodiments, there is difference in that at least a portion of the plurality of low-reflection patterns 3300 are arranged in a convex curved shape to one side or the other side in the first direction, so this difference will be mainly described, and the same description and reference numerals will be referred to the above-described embodiments.

Referring to FIG. 15, at least a portion of the plurality of low-reflection patterns 3300 may be arranged in a convex curved shape to one side or the other side in the first direction. For example, at least a portion of the plurality of low-reflection patterns 3300 may be arranged in the first side portion 3210 in a convex curved shape to one side or the other side in the transverse direction. In addition, at least a portion of the plurality of low-reflection patterns 3300 may have a convex shape on one side or the other in the first direction and may be arranged in a plurality of curved shapes spaced apart from each other in the first direction. For example, at least a portion of the plurality of low-reflection patterns 3300 may have a convex shape on one side or the other in the transverse direction and may be arranged in the first side portion 3210 in a plurality of curved shapes spaced apart from each other in the transverse direction.

The plurality of low-reflection patterns 3300 may be arranged in the side region 3200 to be symmetrical with respect to the virtual first direction center line CL1 extending in the first direction while passing through the center of the reflective sheet 300. For example, the plurality of low-reflection patterns 3300 may be arranged in the first side portion 3210 of the side region 3200 such that they are symmetrical with respect to the virtual first direction center line CL1 extending in the transverse direction while passing through the center of the reflective sheet 300. In addition, the plurality of low-reflection patterns 3300 may be arranged in the side region 3200 to be symmetrical with respect to the virtual second direction center line CL2 extending in the second direction while passing through the center of the reflective sheet 300. For example, the plurality of low-reflection patterns 3300 may be arranged in the first side portion 3210 of the side region 3200 such that they are symmetrical with respect to the virtual second direction center line CL2 extending in the longitudinal direction while passing through the center of the reflective sheet 300.

Meanwhile, in addition to such configurations, according to a sixth embodiment of the present disclosure, the size of the plurality of low-reflection patterns 3300 may become smaller as the distance from the light emitting device 200 increases.

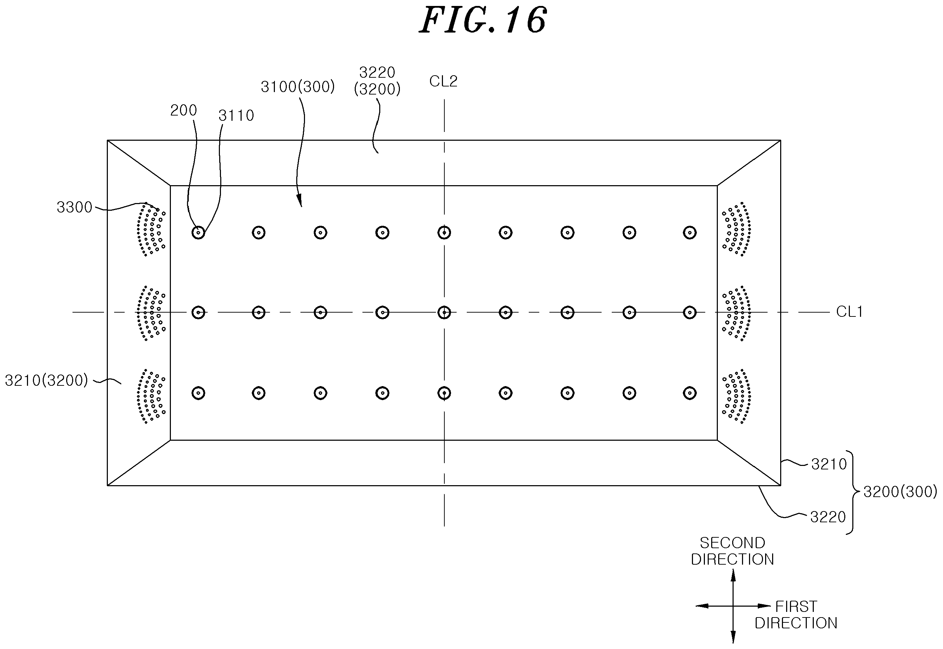

Hereinafter, the sixth embodiment will be described with reference to FIG. 16. In describing the sixth embodiment of the present disclosure, when compared to the above-described embodiments, there is a difference in that the size of the plurality of low-reflection patterns 3300 becomes smaller as the distance from the light emitting device 200 increases, so this difference will be mainly described, and the same description and reference numerals will be referred to the above-described embodiments.

Referring to FIG. 16, the size of the plurality of low-reflection patterns 3300 may become smaller as the distance from the light emitting device 200 increases. For example, the plurality of low-reflection patterns 3300 may have a convex shape on one side or the other in the transverse direction and may be arranged in the first side portion 3210 in a plurality of curved shapes spaced apart from each other in the transverse direction, and the size of the plurality of low-reflection patterns 3300 may become smaller as the distance from the light emitting device 200 increases. The plurality of low-reflection patterns 3300 may be arranged in a fan shape. The plurality of low-reflection patterns 3300 may form a single area, and the width on both sides of the single area may be widened toward the outer edge of the reflective sheet 300. Therefore, the reflectance can be adjusted depending on the distance from the light emitting device 200.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting apparatus comprising:
a circuit board;
a plurality of light emitting devices connected to the circuit board; and
a reflective sheet that reflects light emitted from the plurality of light emitting devices and includes a plurality of reflective cells which respectively accommodate the plurality of light emitting devices,
wherein the plurality of reflective cells include a plurality of low-reflection patterns, and
wherein the plurality of low-reflection patterns include a pattern disposed closer to an edge of the reflective sheet, size of which is relatively smaller than size of other patterns.

2. The light emitting apparatus of claim 1, wherein a reflection area of the plurality of reflective cells increases as the reflective cells are disposed closer to the edge of the reflective sheet.

3. The light emitting apparatus of claim 1, wherein in the plurality of reflective cells, a device area ratio, which is a ratio of a light-emitting area of the light emitting device to an area of the low-reflection pattern, increases as the reflective cells are disposed closer to the edge of the reflective sheet.

4. The light emitting apparatus of claim 1, wherein the light emitting devices and the reflective cells are arranged in a grid pattern, and
a sum of areas of the low-reflection patterns of the plurality of the reflective cells in an edge row is smaller than a sum of areas of the low-reflection patterns of the plurality of the reflective cells in a row passing through a center of the reflective sheet.

5. The light emitting apparatus of claim 1, wherein the reflective sheet includes:
a first zone;
a second zone disposed closer to the edge of the reflective sheet than the first zone; and
a third zone disposed closer to the edge of the reflective sheet than the second zone,
wherein the plurality of low-reflection patterns include:
a first low-reflection pattern included in the reflective cells arranged in the first zone;
a second low-reflection pattern included in the reflective cells arranged in the second zone; and
a third low-reflection pattern included in the reflective cells arranged in the third zone, and
wherein an area of the third low-reflection pattern is smaller than an area of the second low-reflection pattern, and the area of the second low-reflection pattern is smaller than an area of the first low-reflection pattern.

6. The light emitting apparatus of claim 5, wherein a curvature of the first low-reflection pattern and a curvature of the second low-reflection pattern are different from a curvature of the third low-reflection pattern.

7. The light emitting apparatus of claim 5, wherein each of the reflective cells further includes:
a device arrangement portion where the light emitting device is disposed; and
a wall portion forming a boundary with the neighboring reflective cell, and
wherein the wall portions of the reflective cells arranged in the first zone and the second zone have a shape or area different from those of the first low-reflection pattern and the second low-reflection pattern,
wherein the wall portions of the reflective cells arranged in the third zone have a shape corresponding to that of the third low-reflection pattern, and
wherein the third low-reflection pattern has a shape corresponding to the light emitting device.

8. The light emitting apparatus of claim 7, wherein the wall portion has an inclined surface that is inclined to the device arrangement portion.

9. The light emitting apparatus of claim 7, wherein an upper surface or a height of the wall portion is higher than that of the light emitting device.

10. The light emitting apparatus of claim 7, wherein in the plurality of reflective cells, a distance between an edge of the wall portion and an edge of the low-reflection pattern increases as the reflective cells are disposed closer to the edge of the reflective sheet.

11. The light emitting apparatus of claim 1, wherein a distance between an edge of the light emitting device accommodated in each of the plurality of reflective cells and an edge of the low-reflection pattern decreases as the reflective cells are disposed closer to the edge of the reflective sheet.

12. The light emitting apparatus of claim 5, wherein the light emitting devices accommodated in the reflective cells arranged in the first zone have a different beam angle, luminous intensity, or peak wavelength from the light emitting devices accommodated in the reflective cells arranged in the third zone.

13. A light emitting apparatus comprising:
a circuit board;
a plurality of light emitting devices connected to the circuit board; and
a reflective sheet that reflects light emitted from the plurality of light emitting devices and accommodates the plurality of light emitting devices,
wherein the reflective sheet includes a plurality of low-reflection patterns, and
the plurality of low-reflection patterns include a pattern disposed farther from the light emitting device, size of which is relatively smaller than size of other patterns..

14. The light emitting apparatus of claim 13, wherein a distance between the plurality of low-reflection patterns increases as the plurality of low-reflection patterns are disposed farther away from the light emitting device.

15. The light emitting apparatus of claim 13, wherein one of the plurality of low-reflection patterns is smaller in size than another one of the plurality of low-reflection patterns.

16. The light emitting apparatus of claim 13, wherein a density of the low-reflection pattern disposed relatively closer to the light emitting device among the plurality of low-reflection patterns is greater than a density of the low-reflection pattern disposed relatively farther from the light emitting device among the plurality of low-reflection patterns.

17. The light emitting apparatus of claim 13, wherein the light emitting device includes:
a light emitting diode chip connected to the circuit board; and
a light transmitting portion covering the light emitting diode chip.

18. The light emitting apparatus of claim 13, wherein the light emitting device includes:
a package substrate connected to the circuit board;
a chip arrangement layer disposed above the package substrate and having a chip arrangement space formed therein;
a phosphor layer disposed in the chip arrangement space;
a light emitting diode chip disposed in the phosphor layer to be connected to the package substrate; and
a light transmitting portion covering the package substrate, the chip arrangement layer, and the phosphor layer.

19. The light emitting apparatus of claim 15, wherein the light emitting device includes:
a package substrate connected to the circuit board;
a phosphor layer disposed above the package substrate;
a light emitting diode chip disposed in the phosphor layer to be connected to the package substrate; and
a reflective layer disposed above the phosphor layer.

20. A display comprising:
a light emitting apparatus for emitting light; and
a panel for controlling light emitted from the light emitting apparatus,
wherein the light emitting apparatus includes:
a circuit board;
a plurality of light emitting devices connected to the circuit board; and
a reflective sheet that reflects light emitted from the plurality of light emitting devices and includes a plurality of reflective cells which respectively accommodate the plurality of light emitting devices,
wherein the plurality of reflective cells include a plurality of low-reflection patterns, and
wherein the plurality of low-reflection patterns become smaller in size, have lower saturation, or have lower brightness as the plurality of low-reflection patterns are disposed closer to an edge of the reflective sheet.
